# FASCICULE DE BREVET EUROPEEN

(11) **EP 3 690 456 B1**
(45) Date de publication et mention de la délivrance du brevet: **14.07.2021**
(21) Numéro de dépôt: 20154712.2
(22) Date de dépôt: 30.01.2020
(51) Int. Cl.: G01R 29/02

(54) **MESURE DE LA DURÉE D'UNE IMPULSION**
MESSUNG DER DAUER EINES IMPULSES
MEASUREMENT OF THE DURATION OF A PULSE

(30) Priorité: 31.01.2019 FR 1900935
(43) Date de publication de la demande: 05.08.2020
(73) Titulaire: STMICROELECTRONICS SA, 92120 Montrouge (FR); STMicroelectronics (Crolles 2) SAS, 38920 Crolles (FR)
(72) Inventeur: LECAT-MATHIEU DE BOISSAC, Capucine, 38000 GRENOBLE (FR); ABOUZEID, Fady, 38660 LA TERRASSE (FR); GASIOT, Gilles, 38170 SEYSSINET-PARISET (FR); ROCHE, Philippe, 38330 BIVIERS (FR); MALHERBE, Victor, 38000 GRENOBLE (FR)
(74) Mandataire: Cabinet Beaumont

(56) Documents cités:
- EP-A1- 1 961 122
- JP-A- 2011 259 208
- US-A1- 2002 175 730
- KAUPPILA J S ET AL: "Exploiting Parallelism and Heterogeneity in a Radiation Effects Test Vehicle for Efficient Single-Event Characterization of Nanoscale Circuits", IEEE TRANSACTIONS ON NUCLEAR SCIENCE, IEEE SERVICE CENTER, NEW YORK, NY, US, vol. 65, no. 1, 1 janvier 2018 (2018-01-01), pages 486-494, XP011675977, ISSN: 0018-9499, DOI: 10.1109/TNS.2017.2783260 [extrait le 2018-01-17]
- LIU RUI ET AL: "Analysis of advanced circuits for SET measurement", 2015 IEEE INTERNATIONAL RELIABILITY PHYSICS SYMPOSIUM, IEEE, 19 avril 2015 (2015-04-19), XP032780938, DOI: 10.1109/IRPS.2015.7112827
- LIU RUI ET AL: "Single Event Transient and TID Study in 28 nm UTBB FDSOI Technology", IEEE TRANSACTIONS ON NUCLEAR SCIENCE, IEEE SERVICE CENTER, NEW YORK, NY, US, vol. 64, no. 1, 1 janvier 2017 (2017-01-01), pages 113-118, XP011642203, ISSN: 0018-9499, DOI: 10.1109/TNS.2016.2627015 [extrait le 2017-03-02]
- VERONIQUE FERLET-CAVROIS ET AL: "Single Event Transients in Digital CMOS A Review", IEEE TRANSACTIONS ON NUCLEAR SCIENCE, IEEE SERVICE CENTER, NEW YORK, NY, US, vol. 60, no. 3, 1 juin 2013 (2013-06-01), pages 1767-1790, XP011514554, ISSN: 0018-9499, DOI: 10.1109/TNS.2013.2255624
- YANAGAWA Y ET AL: "Direct Measurement of SET Pulse Widths in 0.2-m SOI Logic Cells Irradiated by Heavy Ions", IEEE TRANSACTIONS ON NUCLEAR SCIENCE, IEEE SERVICE CENTER, NEW YORK, NY, US, vol. 53, no. 6, 1 décembre 2006 (2006-12-01), pages 3575-3578, XP011152284, ISSN: 0018-9499, DOI: 10.1109/TNS.2006.885110
- HENZLER S ET AL: "A Local Passive Time Interpolation Concept for Variation-Tolerant High-Resolution Time-to-Digital Conversion", IEEE JOURNAL OF SOLID-STATE CIRCUITS, IEEE SERVICE CENTER, PISCATAWAY, NJ, USA, vol. 40, no. 7, 1 juillet 2008 (2008-07-01), pages 1666-1676, XP011229237, ISSN: 0018-9200

## Description

### Domaine technique

La présente description concerne de façon générale les circuits électroniques. La présente description concerne plus particulièrement les circuits électroniques de mesure de la durée d'une impulsion, notamment les circuits de détection et de caractérisation d'une particule radiative à partir de l'impulsion de tension générée par cette particule lorsqu'elle frappe un circuit combinatoire.

### Technique antérieure

On connaît des circuits de détection et de caractérisation d'une particule radiative comprenant au moins un premier circuit combinatoire configuré pour propager une impulsion générée dans ce circuit combinatoire lorsqu'il est frappé par une particule radiative, et un deuxième circuit configuré pour fournir un signal représentatif de la durée de l'impulsion générée afin de caractériser la particule. En effet, lorsqu'une particule frappe le premier circuit et qu'elle y produit une impulsion transitoire de tension, généralement désignée par le sigle SET ("Single Event Transient"), la durée de l'impulsion est représentative de caractéristiques de la particule, par exemple de son type et/ou de son énergie.

Dans de tels circuits, une erreur sur la mesure de la durée de l'impulsion peut conduire à une caractérisation erronée de la particule. Les documents "Exploiting Parallelism and Heterogeneity in a Radiation Effects Test Vehicle for Efficient Single-Event Characterization of Nanoscale Circuits", KAUPPILA J S ET AL, IEEE TRANSACTIONS ON NUCLEAR SCIENCE, vol. 65, no. 1, 1 janvier 2018, pages 486-494 ; "Analysis of advanced circuits for SET measurement", LIU RUI ET AL, 2015 IEEE INTERNATIONAL RELIABILITY PHYSICS SYMPOSIUM, 19 avril 2015 ; "Single Event Transient and TID Study in 28 nm UTBB FDSOI Technology", LIU RUI ET AL, IEEE TRANSACTIONS ON NUCLEAR SCIENCE, vol. 64, no. 1, 1 janvier 2017, pages 113-118 et EP 1 961 122 A1 divulguent des dispositifs de mesure de la durée d'une impulsion de tension utilisant un vernier à lignes à retard.

### Résumé de l'invention

Il existe un besoin de réduire ou corriger des erreurs de mesure de la durée d'une impulsion transitoire de tension, notamment les erreurs de mesure dues à des variations de fabrication du circuit effectuant cette mesure.

Un mode de réalisation pallie tout ou partie des inconvénients des circuits connus de mesure de la durée d'une impulsion de tension, en particulier des circuits connus de détection et de caractérisation d'une particule radiative.

Un mode de réalisation prévoit un circuit ou dispositif de mesure de la durée d'une impulsion de tension permettant de corriger des erreurs de mesure, notamment dues à des variations de fabrication.

Un mode de réalisation prévoit plus particulièrement un dispositif de mesure de la durée d'une impulsion de tension fournissant des signaux de sortie à partir desquels est évaluée l'erreur sur la mesure de la durée de l'impulsion.

Ainsi, un exemple de réalisation prévoit un dispositif comprenant : un premier circuit comportant une première chaine d'étages identiques définissant des première et deuxième lignes à retard, le premier circuit formant un vernier à lignes à retard dont une entrée est connectée à une entrée de la première ligne à retard et à une entrée de la deuxième ligne à retard et étant configuré pour fournir un signal numérique ou mot binaire représentatif de la durée d'une impulsion reçue par ladite entrée du premier circuit ; un deuxième circuit comportant une deuxième chaine d'étages identiques aux étages de la première chaine, la deuxième chaine définissant des troisième et quatrième lignes à retard ; un troisième circuit ; un quatrième circuit connecté aux extrémités de la troisième ligne à retard et dont une sortie est configurée pour fournir au troisième circuit une première impulsion de durée représentative du retard introduit par la troisième ligne à retard ; un cinquième circuit connecté aux extrémités de la quatrième ligne à retard et configuré pour fournir au troisième circuit une deuxième impulsion de durée représentative du retard introduit par la quatrième ligne à retard, le troisième circuit étant configuré pour fournir sélectivement, à ladite entrée du premier circuit, la première impulsion, la deuxième impulsion ou une impulsion reçue par une première entrée du troisième circuit, en fonction d'un signal de commande reçu par une deuxième entrée du troisième circuit.

Selon un mode de réalisation, le nombre d'étages du deuxième circuit est inférieur au nombre d'étages du premier circuit.

Selon un exemple de réalisation, le premier circuit, de préférence un vernier à lignes à retard, est configuré pour fournir un signal de sortie représentatif d'une durée d'une impulsion reçue par ladite même entrée du premier circuit.

Selon un mode de réalisation, chaque étage de la première chaine introduit un premier retard sur la première ligne à retard et un deuxième retard sur la deuxième ligne à retard, et chaque étage de la deuxième chaine introduit le premier retard sur la troisième ligne à retard et le deuxième retard sur la quatrième ligne à retard, le deuxième retard étant supérieur au premier retard.

Selon un mode de réalisation, chaque étage comprend une bascule synchrone ; un quatrième circuit reliant une première entrée de l'étage à une première sortie de l'étage et à une entrée de donnée de la bascule synchrone, le quatrième circuit étant configuré pour propager un signal avec le premier retard ; et un cinquième circuit reliant une deuxième entrée de l'étage à une deuxième sortie de l'étage et à une entrée de synchronisation de la bascule synchrone, le cinquième circuit étant configuré pour propager un signal avec le deuxième retard.

Selon un mode de réalisation, le dispositif comprend en outre un sixième circuit dont une sortie est connectée à la première entrée du troisième circuit et dont une entrée est destinée à recevoir une impulsion, le sixième circuit étant configuré pour fournir à sa sortie une impulsion plus longue d'une durée donnée que l'impulsion reçue par son entrée.

Selon un mode de réalisation, le dispositif comprend en outre un septième circuit configuré pour fournir sélectivement, à l'entrée du sixième circuit, une des première et deuxième impulsions ou une impulsion reçue sur une première entrée du septième circuit, en fonction d'un signal de commande reçu par une deuxième entrée du septième circuit.

Selon un mode de réalisation, le dispositif comprend en outre au moins un huitième circuit configuré pour propager une impulsion jusqu'à une sortie du huitième circuit, la sortie du huitième circuit étant reliée à la première entrée du septième circuit.

Selon un mode de réalisation, le dispositif comprend en outre un neuvième circuit dont une sortie est reliée à une entrée dudit au moins un huitième circuit, le neuvième circuit étant configuré pour fournir à sa sortie une même impulsion chaque fois qu'une entrée du huitième circuit reçoit un signal de commande correspondant.

Selon un mode de réalisation, le dispositif comprend au moins deux huitièmes circuits.

Selon un mode de réalisation, le dispositif comprend un dixième circuit configuré pour relier sélectivement, en fonction d'un signal de commande reçu par une entrée du dixième circuit, la sortie du neuvième circuit à l'entrée de l'un des huitièmes circuits ; et un onzième circuit configuré pour fournir, à la première entrée du septième circuit, un signal correspondant au OU logique des sorties des huitièmes circuits.

Selon un mode de réalisation, le dispositif comprend un dixième circuit configuré pour relier sélectivement, en fonction d'un signal de commande reçu par une entrée du dixième circuit, les sorties des huitièmes circuits à des sorties correspondantes du dixième circuit ou la sortie d'un seul des huitièmes circuits à la sortie du dixième circuit correspondant audit un seul des huitièmes circuits ; et un onzième circuit configuré pour fournir, à la première entrée du septième circuit, un signal correspondant au OU logique des sorties du dixième circuit.

Selon un mode de réalisation, le dispositif comprend en outre un douzième circuit configuré pour fournir un signal indiquant duquel des huitièmes circuits provient une impulsion reçue par la première entrée du septième circuit.

Selon un exemple de réalisation, le dispositif comprend en outre un circuit de commande configuré pour fournir un signal d'entrée à la troisième ligne à retard et à la quatrième ligne à retard.

Selon un exemple de réalisation, le circuit de commande est en outre configuré pour fournir le signal de commande du troisième circuit et/ou le signal de commande du septième circuit et/ou le signal de commande du neuvième circuit et/ou le signal de commande du dixième circuit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique et sous forme de blocs, un mode de réalisation d'un dispositif adapté à la détection et à la caractérisation d'une particule radiative ;
la figure 2 représente, sous forme de blocs, des étapes d'un mode de mise en oeuvre d'un procédé de calibration ou d'étalonnage du dispositif de la figure 1 ;
la figure 3 représente un exemple de mode de réalisation d'un circuit du dispositif de la figure 1, de manière plus détaillée qu'en figure 1 ;
la figure 4 représente des exemples de modes de réalisation A, B et C d'un autre circuit du dispositif de la figure 1, de manière plus détaillée qu'en figure 1 ;
la figure 5 représente, de manière schématique et sous forme de blocs, une variante de réalisation du dispositif de la figure 1 ;
la figure 6 représente, sous forme de blocs, des étapes d'un mode de mise en oeuvre d'un procédé de calibration ou d'étalonnage du dispositif de la figure 5 ;
la figure 7 représente, de manière schématique et sous forme de blocs, une autre variante de réalisation du dispositif de la figure 1 ;
la figure 8 représente, sous forme de blocs, des étapes d'un mode de mise en oeuvre d'un procédé de calibration ou d'étalonnage du dispositif de la figure 7 ; et
la figure 9 représente, de manière schématique et sous forme de blocs, encore une autre variante de réalisation du dispositif de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la caractérisation d'une particule à partir de l'impulsion transitoire de tension qu'elle produit n'a pas été détaillée, les modes de réalisation décrits étant compatibles avec les caractérisations usuelles d'une particule à partir de l'impulsion qu'elle génère.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, on appelle "signal binaire" un signal qui alterne entre un premier état constant, par exemple un état bas, noté "0", et un deuxième état constant, par exemple un état haut, noté "1". Les états "1" et "0" d'un signal binaire correspondent aux valeurs respectives "1" et "0" d'un bit représenté par ce signal binaire. Les états haut et bas de signaux binaires différents d'un même circuit électronique peuvent être différents. En pratique, les signaux binaires peuvent correspondre à des tensions qui peuvent ne pas être parfaitement constantes à l'état haut ou bas.

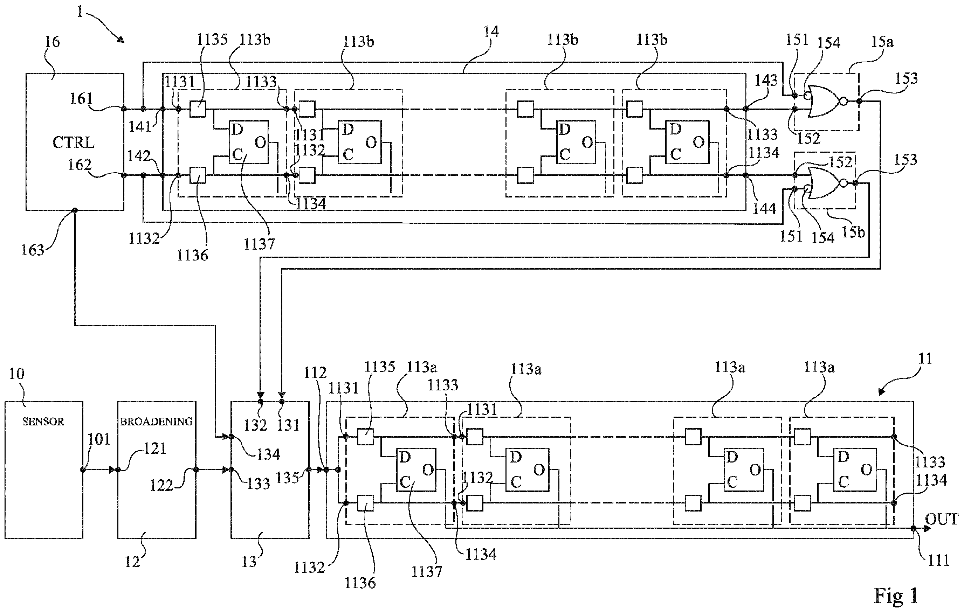

La figure 1 représente, de manière schématique et sous forme de blocs, un mode de réalisation d'un circuit ou dispositif 1 adapté à la détection et à la caractérisation d'une particule radiative.

Le dispositif 1, de préférence un circuit intégré, comprend au moins un circuit ou capteur 10 (SENSOR), un seul capteur 10 dans l'exemple de la figure 1. Le circuit 10 est un circuit combinatoire configuré pour que, lorsqu'une particule radiative frappe le circuit 10 et y produit une impulsion transitoire de tension, le circuit 10 propage cette impulsion, sans la déformer, jusqu'à une sortie 101 du circuit 10.

Le dispositif 1 comprend en outre un circuit 11. Le circuit 11, ici un vernier à lignes à retard ou VDL (Vernier Delay Line), est configuré pour fournir, au niveau d'une sortie 111 du circuit 11, un signal numérique ou mot binaire OUT représentatif de la durée d'une impulsion reçue par une entrée 112 du circuit 11. L'entrée 112 du circuit 11 est reliée à la sortie 101 du circuit 10, dans ce mode de réalisation par l'intermédiaire de deux circuits 12 et 13.

Le circuit 11 comprend une chaine d'étages ou circuits élémentaires 113a identiques, par exemple une chaine de 256 étages 113a. La chaine d'étages 113a est connectée entre l'entrée 112 et la sortie 111 du circuit 11. Chaque étage 113a comprend deux entrées 1131 et 1132, deux sorties 1133 et 1134, deux circuits 1135 et 1136, et une bascule synchrone (flip-flop) 1137. Les entrées 1131 et 1132 du premier étage 113a de la chaine (à gauche en figure 1) sont connectées à une même entrée 112 du circuit 11. Les sorties 1133 et 1134 de chaque étage 113a de la chaine, à l'exception de celles du dernier étage 113a (à droite en figure 1), sont connectées aux entrées respectives 1331 et 1132 de l'étage 113a suivant de la chaine. Dans l'exemple de la figure 1, les sorties 1133 et 1134 du dernier étage 113a de la chaine ne sont pas connectées, ou, autrement dit, sont omises.

Dans chaque étage 113a, le circuit 1135 est connecté entre l'entrée 1131 et la sortie 1133 de l'étage considéré. La sortie du circuit 1135 de cet étage 113a est en outre connectée à une entrée, ici l'entrée de donnée D, de la bascule 1137 de l'étage. La sortie du circuit 1135 de l'étage 113a constitue la sortie 1133 de l'étage. Le circuit 1135 est configuré pour introduire un premier retard T1 entre l'entrée 1131 et la sortie 1133 de l'étage, donc l'entrée D de la bascule 1137. Autrement dit, lorsqu'une impulsion de tension est fournie à l'entrée 1131 de l'étage à un instant t, cette impulsion se retrouve sur l'entrée D de la bascule 1137 et sur la sortie 1133 de l'étage à un instant t+T1 (on désigne ici le retard et la durée du retard par la même référence T1). La connexion en série des circuits 1135 du circuit 11 constitue une première ligne à retard du circuit 11, dont l'entrée correspond à l'entrée 1131 du premier étage 113a de la chaine d'étages 113a. A titre d'exemple, chaque circuit 1135 est constitué de deux inverseurs connectés en série entre l'entrée et la sortie du circuit 1135, ou, autrement dit, entre l'entrée 1131 et la sortie 1133 de l'étage considéré.

De manière similaire, dans chaque étage 113a, le circuit 1136 est connecté entre l'entrée 1132 et la sortie 1134 de l'étage considéré. La sortie 1134 de l'étage, c'est-à-dire la sortie du circuit 1136 de cet étage, est connectée à une entrée, ici l'entrée de synchronisation C, de la bascule 1137 de l'étage. Le circuit 1136 est configuré pour introduire un deuxième retard T2, supérieur au retard T1, entre l'entrée 1132 et la sortie 1134 de l'étage, donc l'entrée C de la bascule 1137. Autrement dit, lorsqu'une impulsion de tension est fournie à l'entrée 1132 de l'étage à un instant t, cette impulsion se retrouve sur l'entrée C de la bascule 1137 et sur la sortie 1134 de l'étage à un instant t+T2 (on désigne ici le retard et la durée du retard par la même référence T2). La connexion en série des circuits 1136 du circuit 11 constitue une deuxième ligne à retard du circuit 11, parallèle à la première ligne à retard du circuit 11, et dont l'entrée correspond à l'entrée 1132 du premier étage 113a de la chaine d'étages 113a. A titre d'exemple, chaque circuit 1136 est constitué de deux inverseurs connectés en série entre l'entrée et la sortie du circuit 1136, ou, autrement dit, entre l'entrée 1132 et la sortie 1134 de l'étage considéré.

Chaque bascule 1137 comprend une sortie O fournissant un signal binaire. L'ensemble des signaux binaires fournis par les sorties O des bascules 1137 du circuit 11, ou, autrement dit la concaténation des bits de sortie des bascules 1137, forme un signal numérique, ou mot binaire, représentatif de la durée de l'impulsion reçue par l'entrée 112 du circuit 11. Dans ce mode de réalisation, chaque bascule 1137 est configurée pour mémoriser, à chaque front montant du signal binaire présent sur son entrée C, l'état haut ou bas du signal binaire présent sur son entrée D, et pour maintenir le signal binaire fourni par sa sortie O à cet état mémorisé jusqu'au prochain front montant sur son entrée C.

Dans l'exemple de la figure 1, le signal OUT correspond à la concaténation des signaux de sortie des bascules 1137 du circuit 11. En variante, le circuit 11 comprend un circuit fournissant le signal OUT à partir l'ensemble des signaux de sortie des bascules 1137, de sorte que le signal OUT corresponde à un mot binaire comprenant moins de bits qu'il n'y a d'étages 113a dans le circuit 11.

Le circuit 12 (BROADENING) comprend une entrée 121 et une sortie 122. L'entrée 121 est reliée, ici connectée, à la sortie 101 du circuit 10. Lorsqu'il reçoit une impulsion de durée Tpulse sur son entrée 121, le circuit 12 est configuré pour fournir, sur sa sortie 122, une impulsion de durée Tbd + Tpulse, avec Tbd une durée constante. Autrement dit, le circuit 12 est configuré pour allonger, d'une durée Tdb, la durée Tpulse d'une impulsion qu'il reçoit.

Dans une variante de réalisation, le circuit 12 peut être omis. Toutefois, en omettant le circuit 12, on s'expose au risque que, lorsqu'une impulsion de tension transitoire est générée par une particule atteignant le circuit 10, la durée de celle-ci soit trop faible pour être détectée par le circuit 11.

Le dispositif 1 comprend en outre un circuit 14 comprenant une chaine d'étages 113b identiques aux étages 113a de la chaine du circuit 11. Le circuit 14 comprend des entrées 141 et 142 connectées aux entrées respectives 1131 et 1132 du premier étage 113b (à gauche en figure 1). Les sorties 1133 et 1134 du dernier étage 113b (à droite en figure 1) sont connectées à des sorties respectives 143 et 144 du circuit 14. Le nombre N d'étages 113b de la chaine du circuit 14 est inférieur au nombre d'étages 113a de la chaine du circuit 11. Les étages 113b sont connectés les uns à la suite des autres de la même façon que les étages 113a. Ainsi, la connexion en série des circuits 1135 du circuit 14 constitue une première ligne à retard du circuit 14, et la connexion en série des circuits 1136 du circuit 14 constitue une deuxième ligne à retard du circuit 14, parallèle à la première ligne à retard du circuit 14. L'entrée de la première ligne à retard du circuit 14 correspond à l'entrée 1131 du premier étage 113b de la chaine d'étages 113b du circuit 14, ou, dit autrement, à l'entrée 141 du circuit 14. De manière similaire, l'entrée de la deuxième ligne à retard du circuit 14 correspond à l'entrée 1131 du premier étage 113b de la chaine d'étages 113b du circuit 14, ou, dit autrement, à l'entrée 141 du circuit 14. En outre, la sortie de la première ligne à retard du circuit 14 correspond à la sortie 1133 du dernier étage 113b de la chaine d'étages 113b du circuit 14, ou, dit autrement, à la sortie 143 du circuit 14. De manière similaire, la sortie de la deuxième ligne à retard du circuit 14 correspond à la sortie 1134 du dernier étage 113b de la chaine d'étages 113b du circuit 14, ou, dit autrement, à la sortie 144 du circuit 14. Dans le circuit 14, les sorties O des bascules 1137 des étages 113b ne sont pas connectées, ou, autrement dit, ne sont pas utilisées pour fournir un signal de sortie du circuit 14.

Le dispositif 1 comprend deux circuits 15a et 15b, de préférence identiques. Le circuit 15a, respectivement 15b, comprend une entrée 151 connectée à l'entrée 141, respectivement 142, du circuit 14, et une entrée 152 connectée à la sortie 143, respectivement 144, du circuit 14. Autrement dit, le circuit 15a est connecté aux extrémités de la première ligne à retard du circuit 14, le circuit 15b étant connecté aux extrémités de la deuxième ligne à retard du circuit 14. Dit encore autrement, l'entrée 151 du circuit 15a, respectivement 15b, est connectée à l'entrée 141 de la première ligne à retard du circuit 14, respectivement à l'entrée 142 de la deuxième ligne à retard du circuit 14, l'entrée 152 du circuit 15a, respectivement 15b, étant connectée à la sortie 143 de la première ligne à retard du circuit 14, respectivement à la sortie 144 de la deuxième ligne à retard du circuit 14. Chaque circuit 15a, 15b comprend une sortie 153. Chaque circuit 15a, 15b est configuré pour fournir une impulsion dont la durée correspond au retard introduit par la ligne à retard du circuit 14 à laquelle il est connecté. Plus particulièrement, dans cet exemple, chaque circuit 15a, 15b est configuré pour fournir un signal binaire de sortie à l'état haut uniquement si les signaux reçus par ses entrées 151 et 152 sont respectivement à l'état haut et à l'état bas. Dit autrement, chaque circuit 15a et 15b est configuré pour fournir une impulsion de durée égale au retard entre un front montant fournit à l'entrée 151 du circuit et un front montant fournit à l'entrée 152 de ce circuit. Dans l'exemple de la figure 1, chaque circuit 15a, 15b comprend une porte NON-OU (NOR) dont une première entrée reçoit l'inverse ou le complément (inverseur 154) du signal reçu par l'entrée 151 du circuit 15a, respectivement 15b, dont une deuxième entrée reçoit le signal reçu par l'entrée 152 du circuit 15a, respectivement 15b, et dont la sortie fournit le signal de sortie du circuit 15a, respectivement 15b. L'homme du métier est en mesure de prévoir d'autres mises en œuvre du circuit 15a, respectivement 15b, configuré pour fournir une impulsion de durée représentative du retard introduit par la ligne à retard aux extrémités de laquelle est connecté le circuit 15a, respectivement 15b, par exemple avec une ou plusieurs portes logiques autre qu'une porte logique NON OU.

Le circuit 13 du dispositif 1 comprend trois entrées 131, 132 et 133 connectées respectivement à la sortie 153 du circuit 15a, à la sortie 153 du circuit 15b et à la sortie 122 du circuit 12. Le circuit 13 comprend également une entrée 134 recevant un signal de commande, et une sortie 135. Le circuit 13 est configuré pour relier sélectivement, en fonction du signal de commande qu'il reçoit, l'une des entrées 131, 132 et 133 à la sortie 135. Ainsi, la première ligne à retard du circuit 14 (ensemble des circuits 1135 du circuit 14) et la deuxième ligne à retard du circuit 14 (ensemble des circuits 1136 du circuit 14) sont sélectivement reliées à l'entrée 112 du circuit 11 par le circuit 13.

Le dispositif 1 comprend également un circuit de commande 16 (CTRL). Le circuit 16 comprend trois sorties 161, 162 et 163 connectées aux entrées respectives 141, 142 et 134 des circuits 14 et 13. Le circuit 16 est configuré pour fournir un signal binaire soit à l'entrée 141, soit à l'entrée 142, ce signal pouvant éventuellement être identique et envoyé simultanément aux deux entrées 141 et 142. Le circuit 16 est en outre configuré pour fournir le signal de commande à l'entrée 134 du circuit 13.

Dans une variante de réalisation non représentée, les entrées 141 et 142 du circuit 14 sont confondues, les sorties 161 et 162 du circuit 16 étant également confondues.

Dans une autre variante non représentée, les sorties 153 des circuits 15a et 15b sont reliées à une unique entrée du circuit 13, par l'intermédiaire d'une fonction logique OU, par exemple par une porte OU. Dans ce cas, le circuit 16 est configuré pour fournir un signal à une première des deux entrées 141 et 142, puis à la deuxième de ces deux entrées.

Lors d'une phase, ou étape, de détection et de caractérisation d'une particule, le circuit 16 commande le circuit 13 de sorte que l'entrée 133 soit reliée à la sortie 135. Lorsqu'une particule frappe le circuit 10 et y produit une impulsion de tension, c'est-à-dire ici un bref passage au niveau haut d'un signal binaire normalement à l'état bas, cette impulsion est transmise au circuit 12 qui allonge de la durée Tbd, la durée Tpulse de l'impulsion. L'impulsion de durée allongée est alors fournie à l'entrée 112 du circuit 11, par l'intermédiaire du circuit 13. Une première impulsion correspondante se propage alors dans la première ligne à retard du circuit 11 (ensemble des circuits 1135 du circuit 11), une deuxième impulsion correspondante se propageant dans la deuxième ligne à retard du circuit 11 (ensemble des circuits 1136 du circuit 11). Les première et deuxième impulsions ont la même durée, ici Tpulse + Tbd, que l'impulsion reçue par le circuit 11. Du fait que le retard T1 est inférieur au retard T2, à chaque étage 113a traversé par les première et deuxième impulsions, la deuxième impulsion est retardée d'une durée T2 - T1 par rapport à la deuxième impulsion. Pour un étage 113a donné, si le retard entre les première et deuxième impulsions est tel que le front montant de la deuxième impulsion se produit alors que la première impulsion est au niveau haut, la sortie O de la bascule 1137 de cet étage 113a est à l'état haut, c'est-à-dire à "1". En revanche, si le retard entre les première et deuxième impulsions est tel que le front montant de la deuxième impulsion se produit alors que le front descendant de la première impulsion a déjà eu lieu, la sortie O de la bascule 1137 de cet étage 113a est à l'état bas, c'est-à-dire à "0". Ainsi, lorsqu'une impulsion de durée Tpulse + Tbd est fournie à l'entrée 112 du circuit 11, le nombre A d'étages 113a dont la bascule 1137 fournit une sortie à "1" est représentatif de la durée Tpulse + Tbd de l'impulsion, cette durée étant comprise entre A*(T2-T1) et (A+1)*(T2-T1). En connaissant les valeurs des retards T1 et T2, et de la durée Tbd, on peut donc déterminer une plage de valeurs dans laquelle est comprise la durée Tpulse de l'impulsion générée dans le circuit 10.

Toutefois, les valeurs réelles ou pratiques des retards T1 et T2 peuvent être différentes des valeurs théoriques connues de ces retards T1 et T2, notamment en raison de dispersions de fabrication du dispositif 1. Le dispositif 1 permet d'évaluer, pour chacun des retards T1 et T2, la valeur pratique ou réelle de ce retard. De cette façon, on peut évaluer la durée de l'impulsion reçue par le circuit 11 avec une plus grande précision que si l'on utilisait uniquement les valeurs théoriques des retards T1 et T2.

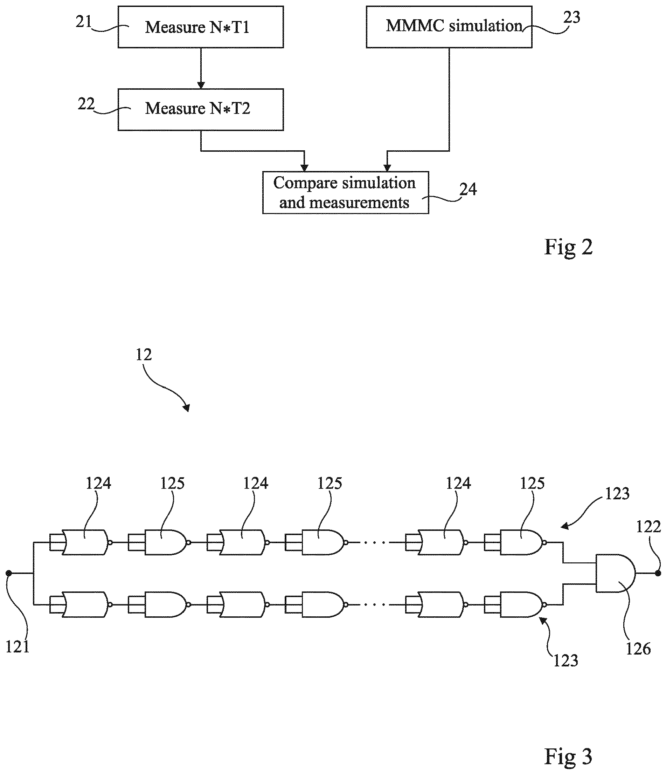

La figure 2 représente, sous forme de blocs, des étapes d'un mode de mise en oeuvre d'un procédé de calibration du dispositif de la figure 1. Plus particulièrement, ce procédé permet d'évaluer, après fabrication du dispositif 1, les valeurs pratiques de chacun des retards T1 et T2 du dispositif 1.

A une étape 21 (bloc "Measure N*T1"), le circuit 16 commande le circuit 13 pour qu'il relie son entrée 131 à sa sortie 134. Le circuit 16 commute ensuite, de l'état bas à l'état haut, le signal binaire fourni à l'entrée 141 du circuit 14. Il en résulte que la sortie 153 du circuit 15a fournit une impulsion de durée N * T1 (avec N le nombre d'étages 113b) qui est transmise, par l'intermédiaire du circuit 13, à l'entrée 112 du circuit 11. Le circuit 11 fournit alors un signal numérique ou mot binaire OUT représentatif de la durée N * T1 de l'impulsion reçue. A la fin de l'étape 21, le circuit 16 commute, de l'état haut à l'état bas, le signal fourni à l'entrée 141 du circuit 14.

A une étape suivante 22 (bloc "Measure N*T2"), l'ordre des étapes 21 et 22 pouvant être inversé, le circuit 16 commande le circuit 13 pour que ce dernier relie son entrée 132 à sa sortie 134. Le circuit 16 commute ensuite, de l'état bas à l'état haut, le signal binaire fourni à l'entrée 142 du circuit 14. Il en résulte que la sortie 153 du circuit 15b fournit une impulsion de durée N * T2 qui est transmise, par l'intermédiaire du circuit 13, à l'entrée 112 du circuit 11. Le circuit 11 fournit alors un signal numérique ou mot binaire OUT représentatif de la durée N * T2 de l'impulsion reçue.

En parallèle des étapes 21 et 22, ou éventuellement avant ou après l'une ou l'autre de ces étapes, à une étape 23 (bloc "MMMC simulation"), on réalise une simulation multi-mode/multi-centrage (Multi-Mode Multi-corner), ou simulation MMMC, du dispositif 1. Cette étape 23 est mise en oeuvre à l'extérieur du dispositif 1, par exemple au moyen d'un ordinateur, par exemple commandé par un opérateur. La simulation MMMC permet de simuler le dispositif 1 en faisant varier les valeurs de plusieurs paramètres, par exemple les valeurs des variations ou dispersions de fabrication, susceptibles de modifier le comportement temporel du dispositif 1, c'est-à-dire les caractéristiques temporelles des portes logiques qui le composent, par exemple les temps de montée, les temps de descente et/ou les temps de propagation de ces portes. La simulation MMMC permet en outre, pour chaque ensemble de valeurs des paramètres de simulation, d'extraire le comportement temporel correspondant du dispositif 1 simulé. Ainsi, pour chaque ensemble de valeurs des paramètres de la simulation, on peut déduire les valeurs des mots binaires qui seraient obtenues en mettant en oeuvre les étapes 21 et 22 dans un dispositif 1 correspondant à cet ensemble de valeurs de paramètre.

A titre d'exemple, la simulation MMMC est effectuée au moyen de l'outil de simulation désigné par l'appellation Incisive, distribué par l'entreprise désignée par l'appellation Cadence, ou par l'outil de simulation désigné par l'appellation Eldo distribué par l'entreprise désignée par l'appellation Mentor. Ces outils s'appuient sur l'estimation, avec des pires cas et des meilleurs cas, d'éléments parasites introduits dans le dispositif 1 résultant de la fabrication, le placement des cellules et/ou des portes du dispositif 1, les espacements des lignes conductrices métalliques reliant ces cellules et/ou ces portes, les variations de capacités, les variations de résistance à l'état passant des transistors constitutifs des cellules et/ou des portes du dispositif 1, etc. Ces données sur les éléments parasites du circuit 1 sont extraites par des outils tels que l'outil désigné par l'appellation StarRC fourni par l'entreprise désignée par l'appellation Synopsis. L'outil désigné par l'appellation PrimeTime et fourni par l'entreprise désignée par l'appellation Synopsis permet également d'effectuer des analyses temporelles et d'extraire des retards de propagation à chaque noeud du circuit 1.

A une étape 24 (bloc "Compare simulation and measurements") postérieure aux étapes 21, 22 et 23, les valeurs des mots binaires OUT obtenus lors des étapes 21 et 22 sont comparées aux valeurs de ces mots binaires déduites lors de l'étape 23. Cette étape 24 est mise en oeuvre à l'extérieur du dispositif 1, par exemple au moyen d'un ordinateur, par exemple contrôlé par un opérateur. Cette comparaison permet de déterminer un ensemble de valeurs des paramètres de la simulation MMMC de l'étape 23 conduisant à un dispositif 1 qui fournirait, aux étapes 21 et 22, des valeurs de mots binaires OUT correspondant aux valeurs des mots binaires OUT obtenues lors de la mise en oeuvre des étapes 21 et 22 avec le dispositif 1 fabriqué. Le comportement temporel du dispositif 1 correspondant à cet ensemble de valeurs de paramètres de simulation fournit une évaluation du comportement temporel du dispositif 1 fabriqué qui est utilisé aux étapes 21 et 22. A partir de cette évaluation du comportement temporel du dispositif 1, on peut évaluer les valeurs des retards T1 et T2 du dispositif 1.

Lors d'une étape suivante (non illustrée) de détection et de caractérisation d'une particule au moyen du dispositif 1, les valeurs des retards T1 et T2 déterminées à l'étape 24 sont utilisées pour calculer une plage de valeurs dans laquelle est comprise la durée Tpulse d'une impulsion générée dans le circuit 10. La plage de valeurs ainsi calculée est alors plus fiable que si elle était déterminée à partir des valeurs théoriques des retards T1 et T2. Autrement dit, l'erreur sur la plage de valeurs à laquelle appartient la durée Tpulse de l'impulsion est plus faible dans le cas où cette plage de valeurs est déterminée avec les valeurs de retards T1 et T2 de l'étape 24 que dans le cas où elle serait déterminée avec les valeurs théoriques de ces retards. Cela résulte notamment du fait que les valeurs des retards T1 et T2 déterminées à l'étape 24 tiennent compte des dispersions de fabrication.

Un avantage du dispositif 1 et du procédé ci-dessus est qu'il ne requiert pas d'utiliser un instrument de mesure externe au dispositif 1. En effet, dans le cas de circuits 1135 et 1136 chacun constitué de deux inverseurs en série, on aurait pu penser réaliser un oscillateur en anneau à inverseurs en rebouclant sur elle-même chacune des première et deuxième lignes à retard du circuit 11. Les valeurs des retards T1 et T2 auraient alors pu être évaluées en mesurant, par exemple à l'aide d'un oscilloscope externe au dispositif 1 mais connecté à celui-ci, la période de chacun des deux oscillateurs ainsi formés. Toutefois, cela impliquerait de prévoir des bornes de connexion supplémentaires pour connecter l'oscilloscope successivement à chacun des oscillateurs en anneau. En outre, l'erreur de mesure introduite par l'oscilloscope, par l'opérateur manipulant l'oscilloscope et/ou par les limitations en bande passante de la connexion entre le dispositif 1 et l'oscilloscope conduirait à des valeurs des retards T1, T2 erronées.

La figure 3 représente un exemple d'un mode de réalisation du circuit 12 du dispositif 1, de manière plus détaillée qu'en figure 1.

Dans cet exemple, le circuit 12 comprend deux chaines identiques 123, chacune constituée d'une alternance de premières et deuxièmes portes logiques, respectivement 124 et 125. Les portes 124 sont identiques les unes aux autres. En outre, chaque porte 124 a un temps de montée supérieur à son temps de descente. Les portes 125 sont identiques les unes aux autres. Chaque porte 125 a un temps de montée inférieur à son temps de descente. En outre, les premières portes 124 et deuxièmes portes 125 sont choisies de sorte qu'une impulsion fournie à l'entrée 121 du circuit 12 soit propagée jusqu'à la sortie 122 de ce circuit 12. C'est la différence entre les temps de montée et de descente des portes 124 et 125, et le nombre de portes 124, 125 par chaine 123 qui fixent la valeur de la durée Tbd.

Plus particulièrement, dans chaque chaine 123, les entrées de la première porte de la chaine, dans cet exemple une porte 124, sont connectées à l'entrée 121 du circuit 12, la sortie de la dernière porte de la chaine, dans cet exemple une porte 125, est connectée à une entrée respective d'une porte ET (AND) 126 à deux entrées, et la sortie de chaque porte de la chaine, à l'exception de la dernière porte, est connectée aux entrées de la porte suivante de la chaine. La sortie de la porte ET 126 est connectée à la sortie 122 du circuit 12.

Dans l'exemple de la figure 3, les premières portes 124 sont des portes logiques NON-OU (NOR) à trois entrées, et les deuxièmes portes 125 sont des portes logiques NON-ET (NAND) à trois entrées. A titre d'exemple, chaque chaine 123 comprend au moins 10 portes 124, 125, par exemple 20 portes 124, 125.

La prévision des deux chaines 123 reliées à la sortie 122 du circuit 12 par l'intermédiaire de la porte ET 126 permet de supprimer une éventuelle impulsion de tension générée directement dans l'une des chaines 123, par une particule atteignant cette chaine 123. Cela permet également de réduire l'impact, sur le fonctionnement du circuit 12, des variations de fabrication entre les deux chaines 123.

Dans une variante non illustrée, le circuit 12 ne comprend qu'une chaine 123, la porte 126 étant omise et la sortie de la chaine 123 étant directement connectée à la sortie. Dans cette variante, une impulsion générée directement dans la chaine 123 ne sera pas supprimée et sera perçue, par le circuit 11, comme une impulsion provenant du circuit 10. Autrement dit, cela conduira à une mauvaise caractérisation de la particule.

L'homme du métier est en mesure de concevoir, à partir des indications fonctionnelles ci-dessus, de nombreuses variantes de réalisation du circuit 12.

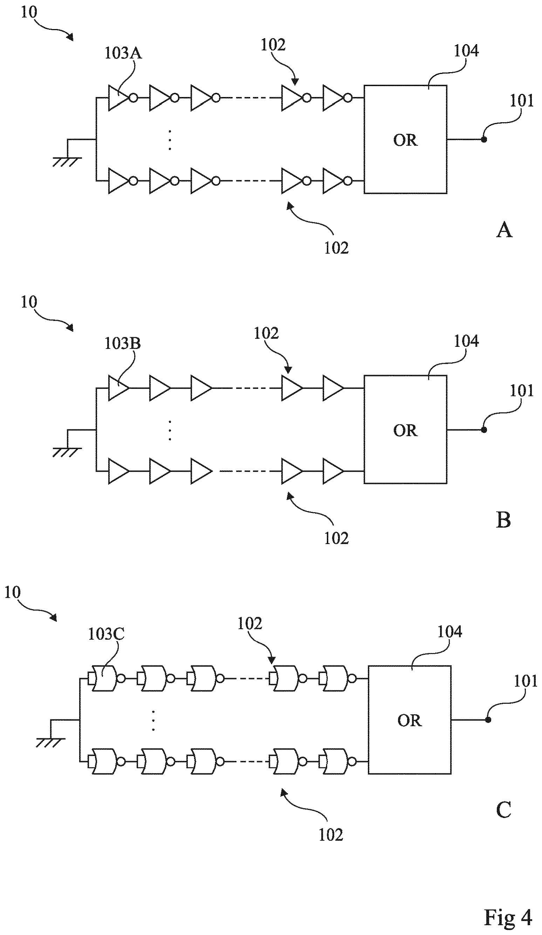

La figure 4 représente des exemples de modes de réalisation A, B et C du circuit 10 du dispositif 1, de manière plus détaillée qu'en figure 1.

Dans chacun des modes de réalisation A, B et C, le circuit 10 comprend une pluralité de chaines 102 identiques, chacune constituée de la connexion en série de plusieurs portes logiques identiques, respectivement 103A, 103B et 103C. L'entrée de chaque chaine 102 du circuit 10 reçoit un signal binaire, ici à l'état bas, par exemple en étant connectée à la masse comme cela est représenté en figure 4. La sortie de chaque chaine 102 du circuit 10 est connectée à une entrée correspondante d'un circuit 104 (OR). La sortie du circuit 104 est connectée à la sortie 101 du circuit 10 et fournit un signal binaire correspondant au OU logique des signaux binaires présents sur ses entrées. A titre d'exemple, le circuit 104 est un arbre de portes OU (OR-tree), de préférence équilibré, c'est-à-dire que chaque chemin conducteur reliant une entrée du circuit 104 à la sortie 101 du circuit 10, traverse un même nombre de portes OU identiques.

Les portes 103A, 103B et 103C des chaines 102 sont choisies de sorte que, lorsqu'une particule frappe une chaine 102 et y génère une impulsion de tension, cette impulsion est propagée jusqu'à la sortie 101 du circuit 10, sans modification ou presque de sa durée. Autrement dit, chaque porte 103A, 103B et 103C a un temps de montée égal à son temps de descente. Dans les modes de réalisation décrits en figures 4, les portes 103A, 103B et 103C sont respectivement des inverseurs, des tampons (buffer) et des portes NON-OU à deux entrées.

A titre d'exemple, chaque chaine 102 comprend aux moins 50 portes 103, par exemple 100 portes 103. A titre d'exemple, le circuit 10 comprend au moins 50 chaines 102, de préférence au moins 100 chaines 102, par exemple 1000 chaines 102.

L'homme du métier est en mesure de concevoir, à partir des indications fonctionnelles ci-dessus, de nombreuses variantes de réalisation du circuit 10.

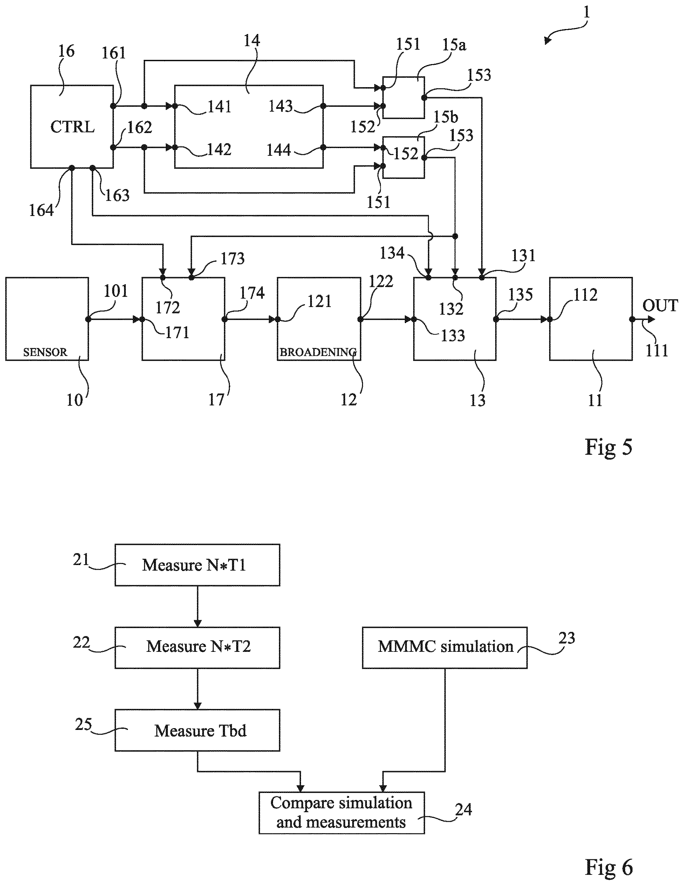

La figure 5 représente, de manière schématique et sous forme de blocs, une variante de réalisation du dispositif 1. Seules les différences entre le dispositif 1 de la figure 1 et le dispositif 1 de la figure 5 sont détaillées.

Par rapport au dispositif 1 de la figure 1, le dispositif 1 de la figure 5 comprend un circuit 17 supplémentaire dont une entrée 171 est connectée à la sortie 101 du circuit 10 et dont une sortie 174 est connectée à l'entrée 121 du circuit 12. Autrement dit, la sortie 101 du circuit 10 n'est pas directement connectée à l'entrée 121 du circuit 12. Le circuit 17 comprend en outre une entrée 172 connectée à une sortie 164 supplémentaire du circuit 16 pour recevoir un signal de commande fourni par le circuit 16. Le circuit 17 comprend également une entrée 173 connectée à la sortie 153 de l'un des circuits 15a et 15b, de préférence celui des circuits 15a et 15b fournissant l'impulsion la plus longue, ici le circuit 15b. Le circuit 17 est configuré pour relier sélectivement, en fonction du signal de commande qu'il reçoit sur son entrée 172, l'une de ses entrées 171 et 173 à sa sortie 174. Le circuit 16 est en outre configuré pour fournir, lors d'une étape de détection et de caractérisation d'une particule, un signal de commande à l'entrée 172 du circuit 17 de sorte que le circuit 17 relie alors son entrée 171 à sa sortie 174.

La figure 6 représente, sous forme de blocs, des étapes d'un mode de mise en oeuvre d'un procédé de calibration ou d'étalonnage du dispositif 1 de la figure 5. Plus particulièrement, ce procédé permet d'évaluer, après fabrication du dispositif 1 de la figure 5, les valeurs pratiques des retards T1 et T2, et de la durée Tbd du dispositif 1 fabriqué. Seules les différences entre le procédé de la figure 6 et le procédé de la figure 2 sont détaillées.

Par rapport au procédé de la figure 2, le procédé de la figure 6 comprend une étape supplémentaire 25. L'étape 25 est mise en oeuvre avant l'étape 24, dans cet exemple après les étapes 21 et 22 bien que l'ordre des étapes 21, 22 et 25 puisse être modifié.

A l'étape 25 ("Measure Tbd"), le circuit 16 commande le circuit 13 de sorte qu'il relie son entrée 133 à sa sortie 135, et le circuit 17 de sorte qu'il relie son entrée 173 à sa sortie 174. Le circuit 16 commute ensuite, de l'état bas à l'état haut, le signal binaire fourni à l'entrée 142 du circuit 14. Il en résulte que la sortie 153 du circuit 15b fournit une impulsion de durée N * T2 qui est transmise, par l'intermédiaire du circuit 17, à l'entrée 121 du circuit 12. La sortie 122 du circuit 12 fournit donc une impulsion de durée N * T2 + Tbd, qui est transmise à l'entrée 112 du circuit 11. Le circuit 11 fournit alors un signal numérique ou mot binaire OUT représentatif de la durée N * T2 + Tbd de l'impulsion reçue. On notera que dans le cas où l'entrée 173 du circuit 17 est connectée au circuit 15a, l'impulsion fournie à l'entrée 173 du circuit 17 a une durée N * T1, et l'impulsion correspondante fournie au circuit 13 a une durée N * T1 + Tbd.

Par ailleurs, à l'étape 23, à partir de la simulation MMMC du dispositif 1 et de manière similaire à ce qui a été décrit en relation avec la figure 2, on déduit, pour chaque ensemble de valeurs des paramètres de cette simulation, les valeurs des mots binaires OUT qui seraient obtenues en mettant en oeuvre les étapes 21, 22 et 25 dans un dispositif 1 correspondant à cet ensemble de valeurs de paramètres de simulation.

A l'étape 24 postérieure aux étapes 21, 22, 23 et 25, de manière similaire à ce qui a été décrit en relation avec la figure 2, les valeurs des mots binaires OUT obtenus lors de la mise en oeuvre des étapes 21, 22 et 25 par le dispositif 1 sont comparées aux valeurs de ces mots binaires déduites lors de l'étape 23. Cette étape 24 est mise en oeuvre à l'extérieur du dispositif 1, par exemple au moyen d'un ordinateur, par exemple contrôlé par un opérateur. Cette comparaison permet de déterminer un ensemble de valeurs des paramètres de la simulation MMMC de l'étape 23 conduisant à un dispositif 1 qui fournirait, aux étapes 21, 22 et 25, des valeurs de mots binaires OUT correspondant aux valeurs des mots binaires OUT obtenues lors de la mise en oeuvre des étapes 21, 22 et 25 avec le dispositif 1 fabriqué. Le comportement temporel du dispositif 1 correspondant à cet ensemble de valeurs de paramètres de simulation fournit une évaluation du comportement temporel du dispositif 1 fabriqué qui est utilisé aux étapes 21, 22 et 25. A partir de cette évaluation du comportement temporel du dispositif 1, on peut évaluer les valeurs des retards T1 et T2, et de la durée Tbd du dispositif 1 utilisé aux étapes 21, 22 et 25.

Comme cela a été décrit pour les retards T1 et T2 en relation avec la figure 2, le procédé de la figure 6 permet d'obtenir une évaluation de la durée Tbd plus proche de la valeur réelle ou pratique de cette durée que la valeur théorique ou idéale de cette durée. En outre, du fait que le procédé de la figure 6 comprend l'étape supplémentaire 25 par rapport au procédé de la figure 2, l'évaluation des retards T1 et T2 avec le procédé de la figure 6 est plus précise qu'avec le procédé de la figure 2. En effet, l'étape 15 fournit une troisième valeur représentative du comportement temporel du dispositif 1 que l'on caractérise. Autrement dit, l'étape 25 fournit un troisième point de comparaison entre les données réelles fournies par le circuit 1 à caractériser et les données obtenues en simulation. Par exemple, si le dispositif 1 fournit deux mots binaires OUT lors de la mise en oeuvre des étapes 21 et 22, et que la simulation MMMC de l'étape 23 fournit au moins deux ensembles de valeurs de paramètres de simulation conduisant à l'obtention de ces deux mots binaires OUT, l'étape 25 fournit un troisième mot binaire OUT qui permettra de sélectionner l'ensemble de paramètres de simulation représentant le mieux le comportement temporel du dispositif 1 que l'on caractérise.

Ainsi, lors d'une étape suivante (non illustrée) de détection et de caractérisation d'une particule, l'évaluation de la durée Tpulse de la particule est mise en oeuvre en utilisant les valeurs évaluées des durées T1, T2 et Tbd, déterminées à l'étape 24. Cela permet de réduire l'erreur sur la plage de valeur à laquelle appartient la durée Tpulse de l'impulsion par rapport au cas où cette détermination serait effectuée avec une valeur théorique de la durée Tbd, notamment du fait que la valeur évaluée de la durée Tbd qui est déterminée à l'étape 24 tient compte des dispersions de fabrication, en particulier dans le circuit 12.

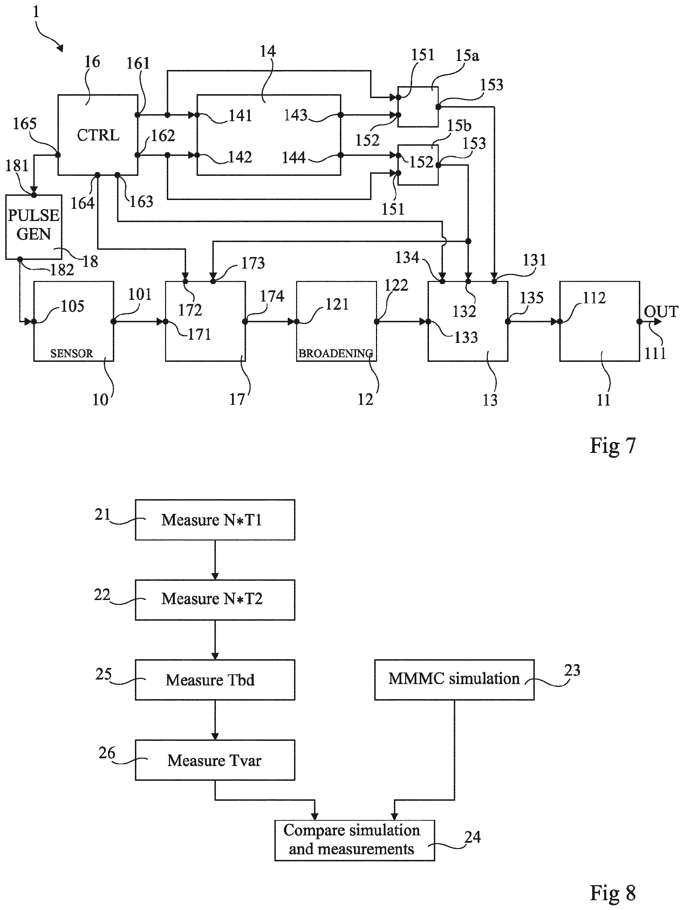

La figure 7 représente, de manière schématique et sous forme de blocs, une autre variante de réalisation du dispositif 1 de la figure 1. Seules les différences entre le dispositif 1 de la figure 5 et le dispositif 1 de la figure 7 sont détaillées.

Dans le dispositif 1 de la figure 7, le circuit 10 comprend une entrée 105, et au moins une chaine 102 du circuit 10 (figure 4), de préférence une seule chaine 102, a son entrée connectée à l'entrée 105 du circuit 10.

En outre, par rapport au dispositif 1 de la figure 5, le dispositif 1 de la figure 7 comprend un circuit 18 (PULSE GEN) supplémentaire. Le circuit 18 comprend une entrée 181 connectée à une sortie supplémentaire 165 du circuit 16 pour recevoir un signal de commande du circuit 16. Le circuit 18 comprend en outre une sortie 182 connectée à l'entrée 105 du circuit 10, pour fournir, lorsque le circuit 18 reçoit un signal de commande correspondant sur son entrée 181, une impulsion d'une durée Tpulse constante à l'entrée 105 du circuit 10.

La figure 8 représente, sous forme de blocs, des étapes d'un mode de mise en oeuvre d'un procédé de calibration ou d'étalonnage du dispositif 1 de la figure 7. Plus particulièrement, ce procédé permet d'évaluer, après fabrication du dispositif 1 de la figure 7, les valeurs pratiques de la durée Tbd et de chacun des retards T1 et T2 du dispositif 1 fabriqué ainsi que le comportement temporel du circuit 10. Seules les différences entre le procédé de la figure 6 et le procédé de la figure 8 sont détaillées.

Par rapport au procédé de la figure 6, le procédé de la figure 8 comprend une étape supplémentaire 26 (bloc "Measure Tvar"). L'étape 26 est mise en oeuvre avant l'étape 24, dans cet exemple après les étapes 21, 22 et 25, bien que l'ordre des étapes 21, 22, 25 et 26 puisse être modifié.

A l'étape 26, le circuit 16 commande le circuit 13 de sorte qu'il relie son entrée 133 à sa sortie 135, et le circuit 17 de sorte qu'il relie son entrée 171 à sa sortie 174. Le circuit 16 fournit ensuite un signal de commande à l'entrée 181 du circuit 18 de sorte que la sortie 182 du circuit 18 fournisse une impulsion de durée Tpulse à l'entrée 105 du circuit 10. L'impulsion se propage alors successivement jusqu'à la sortie 101 du circuit 10, puis de l'entrée 171 à la sortie 174 du circuit 17, puis de l'entrée 121 à la sortie 122 du circuit 12, et enfin de l'entrée 133 à la sortie 135 du circuit 13. Il en résulte que le circuit 11 reçoit une impulsion de durée Tpulse + Tbd +Tvar et fournit un mot binaire OUT représentatif de cette durée, Tvar représentant un élargissement parasite occasionné lors de la propagation de l'impulsion de durée Tpulse dans la chaine 102 du circuit 10.

Par ailleurs, à l'étape 23, à partir de la simulation MMMC du dispositif 1 et de manière similaire à ce qui a été décrit en relation avec les figures 2 et 6, on déduit, pour chaque ensemble de valeurs des paramètres de cette simulation, les valeurs des mots binaires OUT qui seraient obtenues en mettant en oeuvre les étapes 21, 22, 25 et 26 dans un dispositif 1 correspondant à cet ensemble de valeurs de paramètres de simulation.

A l'étape 24 postérieure aux étapes 21, 22, 23, 25 et 26, de manière similaire à ce qui a été décrit en relation avec les figures 2 et 6, les valeurs des mots binaires OUT obtenus lors des étapes 21, 22, 25 et 26 sont comparées aux valeurs de ces mots binaires déduites lors de l'étape 23. Cette étape 24 est mise en oeuvre à l'extérieur du dispositif 1, par exemple au moyen d'un ordinateur, par exemple contrôlé par un opérateur. Cette comparaison permet de déterminer un ensemble de valeurs des paramètres de la simulation MMMC de l'étape 23 conduisant à un dispositif 1 qui fournirait des valeurs de mots binaires OUT correspondant aux valeurs obtenues lors de la mise en oeuvre des étapes 21, 22, 25 et 26 par le dispositif 1 fabriqué. Le comportement temporel du dispositif 1 correspondant à cet ensemble de valeurs de paramètres de simulation fournit une évaluation du comportement temporel du dispositif 1 fabriqué qui est utilisé aux étapes 21, 22, 25 et 26. A partir de cette évaluation du comportement temporel du dispositif 1, on peut évaluer les valeurs des retards T1 et T2 et de la durée Tbd du dispositif 1 utilisé aux étapes 21, 22, 25 et 26, ainsi que de la durée Tvar. L'évaluation de la durée Tvar renseigne sur le comportement temporel de la chaine 102 (figure 4) du circuit 10 de ce dispositif 1, donc le comportement temporel du circuit 10.

Ainsi, la prévision de l'étape 26 apporte une information sur le comportement temporel du circuit 10, en s'appuyant sur les valeurs T1, T2 et Tbd évaluées.

Lors d'une étape suivante (non illustrée) de détection et de caractérisation d'une particule, l'évaluation de la durée Tpulse de l'impulsion générée par une particule dans le circuit 10 est mise en oeuvre en utilisant les valeurs évaluées des durées T1, T2 et Tbd qui ont été déterminées à l'étape 24, et en tenant compte de l'évaluation du comportement temporel du circuit 10. Cela permet de réduire l'erreur sur la détermination de la plage de valeurs à laquelle appartient la durée Tpulse de l'impulsion par rapport au cas où cette détermination serait effectuée après la mise en oeuvre du procédé de la figure 6, notamment du fait que le procédé de la figure 8 permet d'évaluer le comportement temporel du circuit 10 en tenant compte des dispersions de fabrication dans le dispositif 1, et en particulier dans le circuit 10.

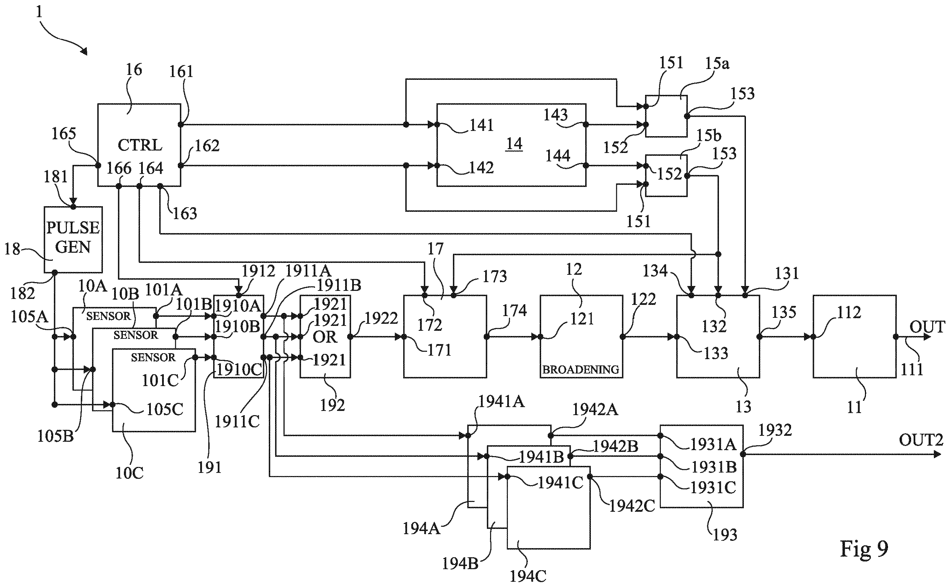

La figure 9 représente, de manière schématique et sous forme de blocs, encore une autre variante de réalisation du dispositif 1 de la figure 1. Seules les différences entre le dispositif 1 de la figure 9 et le dispositif 1 de la figure 7 sont détaillées.

Le dispositif 1 de la figure 9 diffère de celui de la figure 7 essentiellement en ce qu'il comprend au moins deux circuits 10. Dans cet exemple, le dispositif 1 comprend trois circuit 10, référencés respectivement 10A, 10B et 10C. En figure 9, les entrées et sorties des circuits 10A, 10B et 10C sont désignées par les références de l'entrée et de la sortie correspondantes du circuit 10 de la figure 7, auxquelles ont été accolées les lettres respectivement A, B et C.

Les circuits 10A, 10B et 10C sont ici différents les uns des autres, les circuits 10A, 10B et 10C correspondant par exemple aux modes de réalisation respectifs A, B et C décrits en relation avec la figure 4. En variante, certains au moins des circuits 10A, 10B et 10C peuvent être identiques.

Chacune des entrées 105A, 105B et 105C des circuits respectifs 10A, 10B et 10C est connectée à la sortie 182.

Chacune des sorties 101A, 101B et 101C est reliée à une entrée correspondante, respectivement 1910A, 1910B, 1910C, d'un circuit 191 du dispositif 1. Le circuit 191 comprend des sorties 1911A, 1911B et 1911C. Le circuit 191 comprend en outre une entrée 1912 connectée à une sortie 166 supplémentaire du circuit 16, pour recevoir un signal de commande du circuit 16. En fonction du signal de commande reçu par son entrée 1912, le circuit 191 est configuré pour sélectivement relier toutes les entrées 1910A, 1910B et 1910C aux sorties respectives 1911A, 1911B et 1911C, ou une seule des entrées 1910A, 1910B et 1910C à la sortie 1911A, 1911B ou 1911C correspondante, cette unique entrée étant alors déterminée par le signal de commande reçu.

Chacune des sorties 1911A, 1911B et 1911C du circuit 191 est connectée à une entrée respective 1921 d'un circuit 192 (OR) du dispositif 1. Le circuit 192 est configuré pour réaliser une opération ou fonction logique OU entre les signaux binaires présents sur ses entrées 1921, et fournir le signal binaire résultant sur sa sortie 1922. La sortie 1922 du circuit 192 est connectée à l'entrée 171 du circuit 17.

Les sorties 1911A, 1911B et 1911C du circuit 191 sont en outre reliées à des entrées respectives 1931A, 1931B et 1931C d'un circuit 193 du dispositif 1. Le circuit 193 comprend une sortie 1932 fournissant un signal OUT2 de sortie du dispositif 1. Lorsque le circuit 193 reçoit une impulsion sur une de ses entrées 1931A, 1931B, 1931C, le signal OUT2 est représentatif de l'entrée ayant reçu l'impulsion. De préférence, le circuit 193 comprend au moins une bascule configurée pour capturer une impulsion présente sur l'une des entrées 1931A, 1931B et 1931C, de sorte que l'état du signal OUT2 puisse être maintenu pendant plusieurs cycles d'un signal de synchronisation, par exemple un signal d'horloge. Le signal OUT2 peut ainsi être plus facilement lu par un dispositif externe au circuit 1.

Plus particulièrement, dans l'exemple de la figure 9, les sorties 1911A, 1911B et 1911C sont reliées aux entrées respectives 1931A, 1931B et 1931C par l'intermédiaire de circuits respectivement 194A, 194B et 194C. Les circuits 194A, 194B et 194C sont de préférence identiques. Chaque circuit 194A, 194B et 194C est configuré pour allonger la durée d'une impulsion reçue sur son entrée, respectivement 1941A, 1941B et 1941C, l'impulsion de durée allongée étant alors disponible sur sa sortie, respectivement 1942A, 1942B et 1942C. Les sorties 1942A, 1942B et 1942C sont connectées aux entrées respectives 1931A, 1931B et 1931C du circuit 193. La prévision des circuits 194A, 194B et 194C permet que le circuit 193 détecte plus facilement les impulsions qu'il reçoit. A titre d'exemple, chaque circuit 194A, 194B et 194C est identique au circuit 12.

Dans une variante de réalisation non illustrée, les sorties 1911A, 1911B et 1911C peuvent être directement connectées aux entrées respectives 1931A, 1931B et 1931C, les circuits 194A, 194B et 194C étant alors omis. Toutefois, de manière similaire à ce qui a été indiqué pour les variantes de réalisation où le circuit 12 est omis, l'omission des circuits 194A, 194B et 194C peut conduire à ce que les impulsions fournies au circuit 193 soient trop courtes pour être correctement détectées, par exemple par des bascules du circuit 193.

Lors d'une phase de détection et de caractérisation d'une particule, le circuit 16 commande le circuit 18 de sorte qu'il ne génère aucune impulsion. Le circuit 16 commande également le circuit 191 de sorte que chaque entrée 1910A, 1910B et 1910C soit reliée à la sortie respective 1911A, 1911B et 1911C. Ainsi, lorsqu'une particule frappe l'un des circuits 10A, 10B et 10C, par exemple le circuit 10A, et y génère une impulsion, cette impulsion est propagée jusqu'à l'entrée 171 du circuit 17, de sorte qu'elle peut ensuite être mesurée par le circuit 11 de manière similaire à ce qui a été décrit précédemment. L'impulsion générée dans le circuit 10A est également propagée jusqu'à l'entrée 1931A du circuit 193, dans cet exemple par l'intermédiaire du circuit 194A qui allonge la durée de l'impulsion, et le signal OUT2 fourni par le circuit 193 permet de savoir que l'impulsion a été générée dans le circuit 10A, donc que la particule ayant produit cette impulsion a frappé le circuit 10A.

En outre, dans le dispositif 1 de la figure 9, l'étape 26 du procédé décrit en relation avec la figure 8 peut être mise en oeuvre successivement pour chacun des circuits 10A, 10B et 10C ou pour au moins certains des circuits 10A, 10B et 10C, l'étape 24 étant adaptée en conséquence.

A titre d'exemple, on considère le cas où cette étape 26 est mise en oeuvre pour le circuit 10A. Dans ce cas, à l'étape 26, le circuit 16 commande le circuit 191 de sorte que l'entrée 1910A est reliée à la sortie 1911A, les entrées 1910B et 1910C n'étant pas reliées aux sorties respectives 1911B et 1911C. L'homme du métier est en mesure, à partir de cet exemple, de mettre en oeuvre l'étape 26 pour chacun des circuits 10B et 10C.

Bien que l'on ait représenté en figure 9 des circuits 191 et 193 distincts, l'homme du métier est en mesure, à partir des indications fonctionnelles données ci-dessus, de concevoir un unique circuit mettant en oeuvre les fonctions des deux circuits 191 et 193.

De plus, dans l'exemple de la figure 9, plutôt que de prévoir un circuit 191 connecté aux sorties des circuits 10, on peut prévoir un circuit connecté entre la sortie 182 du circuit 18 et les entrées des circuits 10, ce circuit étant commandé pour transmettre l'impulsion qu'il reçoit à un seul des circuits 10, déterminé par un signal de commande du circuit 16.

On peut également prévoir que le circuit 17 ne comprenne pas d'entrée 172, et que le circuit 191 soit configuré pour sélectivement connecter simultanément ses entrées 1910A, 1910B et 1910C à ses sorties respectives 1911A, 1911B et 1911C (phase de détection), connecter uniquement l'une de ses entrées 1910A, 1910B et 1910C à la sortie respective 1911A, 1911B ou 1911C (étape 26), soit ne connecter aucune de ses entrées 1910A, 1910B et 1910C à ses sorties respectives 1911A, 1911B et 1911C (étapes 21, 22 ou 23). Dans ce cas, le circuit 172 peut être une simple fonction OU, par exemple une porte OU à deux entrées, le circuit 16 étant configuré pour ne pas fournir de signal à l'entrée 141 ou 142 du circuit 14 lors de la mise en oeuvre de l'étape 26 ou d'une étape de détection.

L'homme du métier est en mesure d'adapter le dispositif 1 de la figure 9 et le procédé qui lui est associé à un nombre quelconque de circuits 10, supérieur ou égal à 2.

Par ailleurs, de manière similaire au dispositif 1 de la figure 9, on peut prévoir plusieurs circuits 10 dans le dispositif 1 des figures 1 et 5. Dans le dispositif 1 de la figure 1, un circuit 192 est alors disposé entre les sorties 101 des circuits 10, et l'entrée 121 du circuit 12. Dans le dispositif 1 de la figure 5, un circuit 192 est alors disposé entre les sorties 101 des circuits 10, et l'entrée 171 du circuit 17. Dans ces deux cas, le circuit 191 est omis, les circuits 194 et 193 étant optionnels et directement connectés aux sorties 101 des circuits 10.

En outre, bien que l'on ait décrit en relation avec les figures 5, 7 et 9 un circuit 16 fournissant plusieurs signaux de commande, le circuit 16 peut ne fournir qu'un seul signal de commande représentatif de l'ensemble des signaux de commande décrits précédemment, cet unique signal de commande étant alors fourni à chaque circuit commandé par le circuit 16.

Dans les modes de réalisation et variantes qui ont été décrits, la prévision d'étages 113b identiques aux étages 113a permet que le comportement électrique et temporel des étages 113b soit aussi proche que possible de celui des étages 113a. Dans une variante de réalisation non revendiquée, on peut prévoir que les étages 113b ne comprennent pas de bascule 1137. Dans ce cas, le comportement électrique et temporel des étages 113b sera plus éloigné de celui des étages 113a mais permettra tout de même d'évaluer les valeurs des durées T1, T2 et Tbd au prix d'une précision réduite par rapport aux modes de réalisation où chaque étage 113b comprend une bascule 1137.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, le procédé de la figure 2 peut être mis en oeuvre en utilisant les dispositifs 1 décrits en relation avec les figures 5, 7 et 9, et le procédé de la figure 6 peut être mis en oeuvre en utilisant les dispositifs décrits en relation avec les figures 7 et 9.

Enfin, la mise en oeuvre pratique des modes de réalisation et variantes décrits est à la portée de l'homme du métier à partir des indications fonctionnelles données ci-dessus. En particulier, la mise en oeuvre pratique des circuits 13, 17, 192, 193, et 101 est à la portée de l'homme du métier à partir des indications fonctionnelles données ci-dessus. En outre, le nombre d'étages du circuit 14 peut être sélectionné par l'homme de métier en s'assurant toutefois que le nombre N d'étages du circuit 14 respecte les inégalités N*T1 < M*(T2-T1) et N*T2 < M*(T2-T1), avec M le nombre d'étages 113a du circuit 11. Ainsi, la durée d'une impulsion fournie par le circuit 15a ou 15b au circuit 11 peut être mesurée par le circuit 11, M*(T2-T1) représentant la durée maximale d'une impulsion que le circuit 11 peut mesurer.

## Revendications

1. Dispositif (1) de mesure de la durée d'une impulsion comprenant :
- un premier circuit (11) comportant une première chaine d'étages (113a) identiques définissant des première et deuxième lignes à retard, le premier circuit (11) formant un vernier à lignes à retard dont une entrée (112) est connectée à une entrée de la première ligne à retard et à une entrée de la deuxième ligne à retard, et dont une sortie (111) est configurée pour fournir un signal numérique ou mot binaire de sortie du dispositif représentatif de la durée d'une impulsion reçue par ladite entrée du premier circuit ; ledit dispositif étant **caractérisé en ce qu'**il comprend :
- un deuxième circuit (14) comportant une deuxième chaine d'étages (113b) identiques aux étages de la première chaine, la deuxième chaine définissant des troisième et quatrième lignes à retard ;
- un troisième circuit (13) ;
- un quatrième circuit (15a) ayant une première entrée connectée à une première extrémité de la troisième ligne à retard, une deuxième entrée connectée à une deuxième extrémité de la troisième ligne à retard et une sortie configurée pour fournir au troisième circuit (13) une première impulsion de durée représentative du retard (N*T1) introduit par la troisième ligne à retard lorsqu'un signal binaire est fourni à la première extrémité de la troisième ligne ;
- un cinquième circuit (15b) ayant une première entrée connectée à une première extrémité de la quatrième ligne à retard, une deuxième entrée connectée à une deuxième extrémité de la quatrième ligne à retard et une sortie configurée pour fournir au troisième circuit (13) une deuxième impulsion de durée représentative du retard (N*T2) introduit par la quatrième ligne à retard lorsqu'un signal binaire est fourni à la première extrémité de la quatrième ligne à retard ;
- un noeud (101) adapté à recevoir l'impulsion dont la durée est à mesurer, ledit noeud (101) étant relié à une première entrée (133) du troisième circuit ;
- un circuit de commande configuré pour fournir un signal binaire à la première extrémité de la troisième ligne, un signal binaire à la première extrémité de la quatrième ligne et un signal de commande à une deuxième entrée (134) du troisième circuit,
le troisième circuit (13) étant configuré pour fournir sélectivement, à ladite entrée (112) du premier circuit (11), la première impulsion, la deuxième impulsion ou l'impulsion reçue par la première entrée (133) du troisième circuit (13), en fonction du signal de commande reçu par la deuxième entrée (134) du troisième circuit.

2. Dispositif selon la revendication 1, dans lequel le nombre d'étages (113b) du deuxième circuit (14) est inférieur au nombre d'étages (113a) du premier circuit (11).

3. Dispositif selon la revendication 1 ou 2, dans lequel chaque étage (113a) de la première chaine introduit un premier retard (T1) sur la première ligne à retard et un deuxième retard (T2) sur la deuxième ligne à retard, et dans lequel chaque étage (113b) de la deuxième chaine introduit le premier retard (T1) sur la troisième ligne à retard et le deuxième retard (T2) sur la quatrième ligne à retard, le deuxième retard (T2) étant supérieur au premier retard (T1).

4. Dispositif selon la revendication 3, dans lequel chaque étage (113a, 113b) comprend :
- une bascule synchrone (1137) ;
- un quatrième circuit (1135) reliant une première entrée (1131) de l'étage à une première sortie (1133) de l'étage et à une entrée de donnée (D) de la bascule synchrone, le quatrième circuit étant configuré pour propager un signal avec le premier retard (T1) ; et
- un cinquième circuit (1136) reliant une deuxième entrée (1132) de l'étage à une deuxième sortie (1134) de l'étage et à une entrée de synchronisation (C) de la bascule synchrone, le cinquième circuit étant configuré pour propager un signal avec le deuxième retard (T2).

5. Dispositif selon l'une quelconque des revendications 1 à 4, comprenant en outre un sixième circuit (12) dont une sortie (122) est connectée à la première entrée (133) du troisième circuit (13) et dont une entrée (121) est couplée audit noeud (101), le sixième circuit étant configuré pour fournir à sa sortie (122) une impulsion plus longue d'une durée donnée (Tbd) que l'impulsion reçue par son entrée (121) .

6. Dispositif selon la revendication 5, comprenant en outre un septième circuit (17) configuré pour fournir sélectivement, à l'entrée (121) du sixième circuit (12), une des première et deuxième impulsions ou une impulsion reçue sur une première entrée (171) du septième circuit (17), en fonction d'un signal de commande reçu par une deuxième entrée (172) du septième circuit.

7. Dispositif selon la revendication 6, comprenant en outre au moins un huitième circuit (10, 10A, 10B, 10C) configuré pour propager une impulsion jusqu'à une sortie (101, 101A, 101B, 101C) du huitième circuit, la sortie du huitième circuit étant reliée à la première entrée (171) du septième circuit (17).

8. Dispositif selon la revendication 7, comprenant en outre un neuvième circuit (18) dont une sortie (182) est reliée à une entrée (105, 105A, 105B, 105C) dudit au moins un huitième circuit (10, 10A, 10B, 10C), le neuvième circuit étant configuré pour fournir à sa sortie une même impulsion chaque fois qu'une entrée (181) du neuvième circuit reçoit un signal de commande correspondant.

9. Dispositif selon la revendication 8, comprenant au moins deux huitièmes circuits (10A, 10B, 10C).

10. Dispositif selon la revendication 9, comprenant :
- un dixième circuit configuré pour relier sélectivement, en fonction d'un signal de commande reçu par une entrée du dixième circuit, la sortie (182) du neuvième circuit (18) à l'entrée (105A, 105B, 105C) de l'un des huitièmes circuits (10A, 10B, 10C) ; et
- un onzième circuit (192) configuré pour fournir, à la première entrée (171) du septième circuit (17), un signal correspondant au OU logique des sorties (101A, 101B, 101C) des huitièmes circuits (10A, 10B, 10C), ou comprenant :
- un dixième circuit (191) configuré pour relier sélectivement, en fonction d'un signal de commande reçu par une entrée (1912) du dixième circuit, les sorties (101A, 101B, 101C) des huitièmes circuits (10A, 10B, 10C) à des sorties correspondantes (1911A, 1911B, 1911C) du dixième circuit ou la sortie (101A, 101B, 101C) d'un seul des huitièmes circuits (10A, 10B, 10C) à la sortie (1911A, 1911B, 1911C) du dixième circuit correspondant audit un seul des huitièmes circuits ; et
- un onzième circuit (192) configuré pour fournir, à la première entrée (171) du septième circuit (17), un signal correspondant au OU logique des sorties (1911A, 1911B, 1911C) du dixième circuit.

11. Dispositif selon la revendication 9 ou 10, comprenant en outre un douzième circuit (193) configuré pour fournir un signal (OUT2) indiquant duquel des huitièmes circuits provient une impulsion reçue par la première entrée (171) du septième circuit (17).

12. Dispositif selon la revendication 10, dans lequel le circuit de commande (16) est en outre configuré pour fournir le signal de commande du septième circuit (17) et/ou le signal de commande du neuvième circuit (18) et/ou le signal de commande du dixième circuit (192).

## Patentansprüche

1. Vorrichtung (1) zum Messen der Dauer eines Impulses, die Folgendes aufweist:
- eine erste Schaltung (11), aufweisend eine erste Reihe identischer Stufen (113a), die erste und zweite Verzögerungsleitungen definieren, wobei die erste Schaltung (11) eine Feinabgleich-Verzögerungsleitung bildet mit einem Eingang (112), der mit einem Eingang der ersten Verzögerungsleitung und mit einem Eingang der zweiten Verzögerungsleitung verbunden ist, und mit einem Ausgang (111), der konfiguriert ist zum Vorsehen eines digitalen Ausgangssignals oder eines binären Ausgangsworts der Vorrichtung, das für eine Dauer eines Impulses repräsentativ ist, der vom Eingang der ersten Schaltung empfangen wird, wobei die Vorrichtung **dadurch gekennzeichnet ist, dass** sie Folgendes aufweist:
- eine zweite Schaltung (14) aufweisend eine zweite Reihe identischer Stufen (113b), die zu den Stufen der ersten Reihe identisch sind, wobei die zweite Reihe dritte und vierte Verzögerungsleitungen definiert
- eine dritte Schaltung (13);
- eine vierte Schaltung (15a) mit einem ersten Eingang, der mit einem ersten Ende der dritten Verzögerungsleitung verbunden ist, einem zweiten Eingang, der mit einem zweiten Ende der dritten Verzögerungsleitung verbunden ist, und einem Ausgang, der konfiguriert ist zum Vorsehen an die dritte Schaltung (13) eines ersten Impulses mit einer Dauer, die für die Verzögerung (N*T1) repräsentativ ist, die durch die dritte Verzögerungsleitung eingeführt wird, wenn ein binäres Signal am ersten Ende der dritten Leitung vorgesehen wird;
- eine fünfte Schaltung (15b) mit einem ersten Eingang, der mit einem ersten Ende der vierten Verzögerungsleitung verbunden ist, einem zweiten Eingang, der mit einem zweiten Ende der vierten Verzögerungsleitung verbunden ist, und einem Ausgang, der konfiguriert ist zum Vorsehen an die dritten Schaltung (13) eines zweiten Impulses mit einer Dauer, die für die Verzögerung (N*T2) repräsentativ ist, die durch die vierte Verzögerungsleitung eingeführt wird, wenn ein binäres Signal am ersten Ende der vierten Leitung vorgesehen wird;
- einen Knoten (101), der zum Empfangen des Impulses mit der zu messenden Dauer ausgelegt ist, wobei der Knoten (101) mit einem ersten Eingang (133) der dritten Schaltung gekoppelt ist;
- eine Steuerschaltung, die konfiguriert ist zum Vorsehen eines binären Signals an das erste Ende der dritten Leitung, eines binären Signals an das erste Ende der vierten Leitung und eines Steuersignals an einen zweiten Eingang (134) der dritten Schaltung,
wobei die dritte Schaltung (13) konfiguriert ist zum selektiven Vorsehen, am Eingang (112) der ersten Schaltung (11), des ersten Impulses, des zweiten Impulses oder des vom ersten Eingang (133) der dritten Schaltung (13) empfangenen Impulses, basierend auf dem vom zweiten Eingang (134) der dritten Schaltung empfangenen Steuersignal.

2. Vorrichtung nach Anspruch 1, wobei die Anzahl der Stufen (113b) der zweiten Schaltung (14) kleiner ist als die Anzahl der Stufen (113a) der ersten Schaltung (11).

3. Vorrichtung nach Anspruch 1 oder 2, wobei jede Stufe (113a) der ersten Reihe eine erste Verzögerung (T1) auf der ersten Verzögerungsleitung und eine zweite Verzögerung (T2) auf der zweiten Verzögerungsleitung einführt, und wobei jede Stufe (113b) der zweiten Reihe die erste Verzögerung (T1) auf der dritten Verzögerungsleitung und die zweite Verzögerung (T2) auf der vierten Verzögerungsleitung einführt, wobei die zweite Verzögerung (T2) größer ist als die erste Verzögerung (T1).

4. Vorrichtung nach Anspruch 3, wobei jede Stufe (113a, 113b) Folgendes aufweist:
- ein synchrones Flip-Flop (1137);
- eine vierte Schaltung (1135), die einen ersten Eingang (1131) der Stufe mit einem ersten Ausgang (1133) der Stufe und mit einem Dateneingang (D) des synchronen Flipflops koppelt, wobei die vierte Schaltung konfiguriert ist zum Übertragen eines Signals mit der ersten Verzögerung (T1); und
- eine fünfte Schaltung (1136), die einen zweiten Eingang (1132) der Stufe mit einem zweiten Ausgang (1134) der Stufe und mit einem Synchronisierungseingang (C) des synchronen Flipflops koppelt, wobei die fünfte Schaltung konfiguriert ist zum Übertragen eines Signals mit der zweiten Verzögerung (T2).

5. Vorrichtung nach einem der Ansprüche 1 bis 4, ferner aufweisend eine sechste Schaltung (12) mit einem Ausgang (122), der mit dem ersten Eingang (133) der dritten Schaltung (13) verbunden ist, und mit einem Eingang (121), der mit dem Knoten (101) gekoppelt ist, wobei die sechste Schaltung konfiguriert ist zum Vorsehen, an ihrem Ausgang (122), eines Impulses, der um eine gegebene Dauer (Tbd) länger ist als der an ihrem Eingang (121) empfangene Impuls.

6. Vorrichtung nach Anspruch 5, die ferner eine siebte Schaltung (17) aufweist, die konfiguriert ist zum selektiven Vorsehen, an den Eingang (121) der sechsten Schaltung (12), eines der ersten und zweiten Impulse oder eines an einem ersten Eingang (171) der siebten Schaltung (17) empfangenen Impulses, und zwar basierend auf einem an einem zweiten Eingang (172) der siebten Schaltung empfangenen Steuersignals.

7. Vorrichtung nach Anspruch 6, ferner aufweisend wenigstens eine achte Schaltung (10, 10A, 10B, 10C), die konfiguriert ist zum Übertragen eines Impulses bis zu einem Ausgang (101, 101A, 101B, 101C) der achten Schaltung, wobei der Ausgang der achten Schaltung mit dem ersten Eingang (171) der siebten Schaltung (17) gekoppelt ist.

8. Vorrichtung nach Anspruch 7, ferner aufweisend eine neunte Schaltung (18) mit einem Ausgang (182), der mit einem Eingang (105, 105A, 105B, 105C) der wenigstens einen achten Schaltung (10, 10A, 10B, 10C) gekoppelt ist, wobei die neunte Schaltung konfiguriert ist zum Vorsehen, an ihrem Ausgang, eines gleichen Impulses, und zwar jedes Mal, wenn ein Eingang (181) der neunten Schaltung ein entsprechendes Steuersignal empfängt.

9. Vorrichtung nach Anspruch 8, aufweisend wenigstens zwei achte Schaltungen (10A, 10B, 10C).

10. Die Vorrichtung nach Anspruch 9, aufweisend:
- eine zehnte Schaltung, die konfiguriert ist zum selektiven Koppeln, basierend auf einem von einem Eingang der zehnten Schaltung empfangenen Steuersignal, des Ausgangs (182) der neunten Schaltung (18) mit dem Eingang (105A, 105B, 105C) einer der achten Schaltungen (10A, 10B, 10C); und
- eine elfte Schaltung (192), die konfiguriert ist zum Vorsehen, an den ersten Eingang (171) der siebten Schaltung (17), eines Signals, das dem logischen ODER der Ausgänge (101A, 101B, 101C) der achten Schaltungen (10A, 10B, 10C) entspricht, oder aufweisend
- eine zehnte Schaltung (191), die konfiguriert ist zum selektiven Koppeln, basierend auf einem von einem Eingang (1912) der zehnten Schaltung empfangenen Steuersignals, der Ausgänge (101A, 101B, 101C) der achten Schaltungen (10A, 10B, 10C) mit entsprechenden Ausgängen (1911A, 1911B, 1911C) der zehnten Schaltung oder des Ausgangs (101A, 101B, 101C) einer einzelnen der achten Schaltungen (10A, 10B, 10C) mit dem Ausgang (1911A, 1911B, 1911C) der zehnten Schaltung, der der einzelnen der achten Schaltungen entspricht; und
- eine elfte Schaltung (192), die konfiguriert ist zum Vorsehen, an den ersten Eingang (171) der siebten Schaltung (17), eines Signals, das dem logischen ODER der Ausgänge (1911A, 1911B, 1911C) der zehnten Schaltung entspricht.

11. Vorrichtung nach Anspruch 9 oder 10, die ferner eine zwölfte Schaltung (193) aufweist, die konfiguriert ist zum Vorsehen eines Signals (OUT2), das anzeigt, von welcher der achten Schaltungen ein von dem ersten Eingang (171) der siebten Schaltung (17) empfangener Impuls stammt.

12. Vorrichtung nach Anspruch 10, wobei die Steuerschaltung (16) ferner konfiguriert ist zum Vorsehen des Steuersignals der siebten Schaltung (17) und/oder des Steuersignals der neunten Schaltung (18) und/oder des Steuersignals der zehnten Schaltung (192).

## Claims

1. A device (1) for measuring the duration of a pulse comprising:
- a first circuit (11) comprising a first chain of identical stages (113a) defining first and second delay lines, the first circuit (11) forming a vernier delay line having an input (112) connected to an input of the first delay line and to an input of the second delay line, and having an output (111) configured to provide an output digital signal, or an output binary word, of the device representative of a duration of a pulse received by said input of the first circuit, said device being **characterized in that** it comprises:
- a second circuit (14) comprising a second chain of stages (113b) identical to the stages of the first chain, the second chain defining third and fourth delay lines;
- a third circuit (13);
- a fourth circuit (15a) having a first input connected to a first end of the third delay line, a second input connected to a second end of the third delay line and an output configured to provide to the third circuit (13) a first pulse having a duration representative of the delay (N*T1) introduced by the third delay line when a binary signal is provided to the first end of the third line;
- a fifth circuit (15b) having a first input connected to a first end of the fourth delay line, a second input connected to a second end of the fourth delay line and an output configured to provide to the third circuit (13) a second pulse having a duration representative of the delay (N*T2) introduced by the fourth delay line when a binary signal is provided to the first end of the fourth line;
- a node (101) adapted to receive the pulse having the duration to be measured, said node (101) being coupled to a first input (133) of the third circuit;
- a control circuit configured to provide a binary signal to the first end of the third line, a binary signal to the first end of the fourth line and a control signal to a second input (134) of the third circuit,
the third circuit (13) being configured to selectively provide, to said input (112) of the first circuit (11), the first pulse, the second pulse or the pulse received by the first input (133) of the third circuit (13), based on the control signal received by the second input (134) of the third circuit.

2. The device of claim 1, wherein the number of stages (113b) of the second circuit (14) is smaller than the number of stages (113a) of the first circuit (11).

3. The device of claim 1 or 2, wherein each stage (113a) of the first chain introduces a first delay (T1) on the first delay line and a second delay (T2) on the second delay line, and wherein each stage (113b) of the second chain introduces the first delay (T1) on the third delay line and the second delay (T2) on the fourth delay line, the second delay (T2) being greater than the first delay (T1).

4. The device of claim 3, wherein each stage (113a, 113b) comprises:
- a synchronous flip-flop (1137);
- a fourth circuit (1135) coupling a first input (1131) of the stage to a first output (1133) of the stage and to a data input (D) of the synchronous flip-flop, the fourth circuit being configured to propagate a signal with the first delay (T1); and
- a fifth circuit (1136) coupling a second input (1132) of the stage to a second output (1134) of the stage and to a synchronization input (C) of the synchronous flip-flop, the fifth circuit being configured to propagate a signal with the second delay (T2).

5. The device of any of claims 1 to 4, further comprising a sixth circuit (12) having an output (122) connected to the first input (133) of the third circuit (13) and having an input (121) coupled to said node (101), the sixth circuit being configured to provide at its output (122) a pulse longer by a given duration (Tbd) than the pulse received by its input (121).

6. The device of claim 5, further comprising a seventh circuit (17) configured to selectively provide, to the input (121) of the sixth circuit (12), one of the first and second pulses or a pulse received on a first input (171) of the seventh circuit (17), based on a control signal received by a second input (172) of the seventh circuit.

7. The device of claim 6, further comprising at least one eighth circuit (10, 10A, 10B, 10C) configured to propagate a pulse all the way to an output (101, 101A, 101B, 101C) of the eighth circuit, the output of the eighth circuit being coupled to the first input (171) of the seventh circuit (17).

8. The device of claim 7, further comprising a ninth circuit (18) having an output (182) coupled to an input (105, 105A, 105B, 105C) of said at least one eighth circuit (10, 10A, 10B, 10C), the ninth circuit being configured to provide at its output a same pulse each time an input (181) of the ninth circuit receives a corresponding control signal.

9. The device of claim 8, comprising at least two eighth circuits (10A, 10B, 10C).

10. The device of claim 9, comprising:
- a tenth circuit configured to selectively couple, based on a control signal received by an input of the tenth circuit, the output (182) of the ninth circuit (18) to the input (105A, 105B, 105C) of one of the eighth circuits (10A, 10B, 10C); and
- an eleventh circuit (192) configured to provide, to the first input (171) of the seventh circuit (17), a signal corresponding to the logic OR of the outputs (101A, 101B, 101C) of the eighth circuits (10A, 10B, 10C), or comprising:
- a tenth circuit (191) configured to selectively couple, based on a control signal received by an input (1912) of the tenth circuit, the outputs (101A, 101B, 101C) of the eighth circuits (10A, 10B, 10C) to corresponding outputs (1911A, 1911B, 1911C) of the tenth circuit or the output (101A, 101B, 101C) of a single one of the eighth circuits (10A, 10B, 10C) to the output (1911A, 1911B, 1911C) of the tenth circuit corresponding to said single one of the eighth circuits; and
- an eleventh circuit (192) configured to provide, to the first input (171) of the seventh circuit (17), a signal corresponding to the logic OR of the outputs (1911A, 1911B, 1911C) of the tenth circuit.

11. The device of claim 9 or 10, further comprising a twelfth circuit (193) configured to provide a signal (OUT2) indicating from which of the eighth circuits a pulse received by the first input (171) of the seventh circuit (17) originates.

12. The device of claim 10, wherein the control circuit (16) is further configured to provide the control signal of the seventh circuit (17) and/or the control signal of the ninth circuit (18) and/or the control signal of the tenth circuit (192).
